# EUROPÄISCHE PATENTSCHRIFT

(11) **EP 1 166 336 B1**
(45) Veröffentlichungstag und Bekanntmachung des Hinweises auf die Patenterteilung: **31.05.2006**
(21) Anmeldenummer: 00929256.6
(22) Anmeldetag: 24.03.2000
(51) Int. Cl.: H01L 21/00, F24F 3/16

(54) **ANLAGE ZUR FERTIGUNG VON HALBLEITERPRODUKTEN**
DEVICE FOR MANUFACTURING SEMICONDUCTOR PRODUCTS
INSTALLATION POUR FABRIQUER DES PRODUITS SEMICONDUCTEURS

(30) Priorität: 26.03.1999 DE 19913886
(43) Veröffentlichungstag der Anmeldung: 02.01.2002
(73) Patentinhaber: Infineon Technologies AG, 81669 München (DE)
(72) Erfinder: HEINEMANN, Bernhard, D-85521 Ottobrunn (DE)
(74) Vertreter: Kottmann, Heinz Dieter
(86) Internationale Anmeldenummer: PCT/DE2000/000941
(87) Internationale Veröffentlichungsnummer: WO 2000/059002

(56) Entgegenhaltungen:
- EP-A- 0 450 142
- US-A- 5 259 812
- PATENT ABSTRACTS OF JAPAN vol. 1999, no. 08, 30. Juni 1999 (1999-06-30) -& JP 11 074193 A (TOKYO ELECTRON LTD), 16. März 1999 (1999-03-16)

## Beschreibung

Die Erfindung betrifft eine Anlage zur Fertigung von Halbleiterprodukten gemäß dem Oberbegriff des Anspruchs 1. Eine derartige Fertigungsanlage für Halbleiterprodukte ist bekannt aus Pat. Abstr. of Japan. Vol. 1999. Nr. 8, 30. Juni 1999 (1999-06-30) Kaufmans & JP11 074193 A (Tokyo Electron Ltd.). 16. März 1999 (1999-03-16).

Derartige Anlagen können insbesondere zur Bearbeitung von Wafern vorgesehen sein.

Diese Anlagen umfassen eine Vielzahl von Fertigungseinheiten, mit welchen unterschiedliche Fertigungsprozesse zur Bearbeitung der Wafer durchgeführt werden. Bei diesen Fertigungsprozessen handelt es sich insbesondere um Ätzprozesse. Naßchemieverfahren. Diffusionsprozesse sowie diverse Reinigungsverfahren wie zum Beispiel CMP-Verfahren (Chemical Mechnical Polishing). Für jeden dieser Fertigungsprozesse sind eine oder mehrere Fertigungseinheiten vorgesehen.

Der gesamte Bearbeitungsprozeß der Wafer unterliegt strengen Reinheitsanforderungen, so daß die Fertigungseinheiten in einem Reinraum oder in einem System von Reinräumen angeordnet sind.

Der Reinraum oder das System von Reinräumen ist üblicherweise auf einer Etage eines Gebäudes angeordnet.

Der Reinraum wird mittels eines Luftversorgungssystems mit Zuluft versorgt. Dabei wird die Zuluft über die Decke des Reinraums von oben nach unten in den Reinraum eingeführt. Hierzu wird üblicherweise die Zuluft über ein Kanalsystem bis an die Decke des Reinraums geführt und von dort mittels Gebläsevorrichtungen nach unten in den Reinraum eingeblasen. Zudem können Leitungen des Kanalsystems von der Decke des Reinraums zu teilweise oder vollständig vom Rest des Reinraums abgeschlossenen Fertigungseinheiten geführt sein. Die Zuluft wird dann in den Leitungen des Kanalsystems zu Gebläsevorrichtungen an den Fertigungseinheiten geführt und über diese in den Innenraum der jeweiligen Fertigungseinheit eingeblasen.

Die Luftzufuhr über die Decke des Reinraums erfordert einen erheblichen Energieaufwand. Dies beruht darauf, 1, daß erhebliche Gebläseleistungen benötigt werden, um die Zuluft von der Decke bis in den Bodenbereich des Reinraums zu führen. Der hohe Energieaufwand ergibt sich dabei zum einen durch die große Wegstrecke von der Decke bis zum Boden des Reinraums. Zum anderen ist die Zuluft im allgemeinen kühler als die aus dem Reinraum abzuführende Abluft, welche sich durch die Wärmeabgabe der umgebenden Anlagen, insbesondere den Fertigungseinheiten sowie Maschinen zum Antrieb des Transportsystems, welches die Wafer innerhalb der Anlage den Fertigungseinheitne zuführt, erhitzt. Die erhitzte Abluft steigt infolge von Konvektion nach oben zur Decke des Reinraums. Die Gebläsevorrichtungen müssen daher bei großer Gebläseleistung arbeiten, um die Zuluft gegen die aufsteigende Abluft nach unten zu blasen.

Dasselbe gilt für die Luftzufuhr zu den Fertigungseinheiten. Dort muß die Zuluft zunächst über die Leitungen des Kanalsystems von der Decke des Reinraums nach unten zu den Fertigungseinheiten geführt werden. Die typischen Wegstrecken der Leitungen betragen etwa 2,1 m bis 4,3 m. Aufgrund der Größe dieser Wegstrecke ist bereits ein erheblicher Energieaufwand erforderlich, um die Zuluft bis an die Fertigungseinheiten zu führen. Dort wird die Zuluft üblicherweise wieder von der Decke der Fertigungseinheit nach unten geblasen. Dies erfordert wiederum einen hohen Energieaufwand, da die Zuluft gegen die hochsteigende erwärmte Abluft in der Fertigungseinheit nach unten geblasen werden muß.

Nachteilig ist ferner, daß die Zuluft mehr oder minder strengen Reinheitsanforderungen genügen muß, damit die Fertigungsprozesse in den Fertigungseinheiten einwandfrei durchführbar sind.

Da die Wafer im Bereich des Bodens des Reinraums bearbeitet werden, müssen dort die Reinheitsanforderungen an die Zuluft erfüllt sein. Dies ist jedoch nur mit großem Aufwand an Kosten und Material erreichbar, da sich die von der Decke des Reinraums eingeblasene Zuluft bei der Abwärtsströmung im Reinraum mit der bereits verbrauchten und verschmutzten Abluft durchmischt.

JP11 074193 A (Tokyo Electron Ltd.). 16. März 1999 (1999-03-16) beschreibt eine Fertigungsanlage für Halbleiterprodukte, bei der die Luftzufuhr von oben erfolgt. Dies wird insbesondere aus den Figuren 2 und 5 dieser Druckschrift deutlich.

Fig. 6 und im Detail Fig. 7 dieser Druckschrift zeigen eine Vorrichtung, die keine Fertigungsanlage und auch kein Reinraum ist, sondern eine Filtervorrichtung, die in Fig. 5 ganz links unten zu erkennen ist. Diese Filtervorrichtung enthält Spraydüsen, mit denen der unten in das Filter eingeleitete und nach oben aufsteigende Luftstrom zur Reinigung mit Reinwasser benetzt wird, und das in Wassersammelbecken aufgesammelte Wasser wird anschließend mit UV-Strahlung bestrahlt, um eventuelle Keime im Wasser abzutöten. Die Luft wird der Filtervorrichtung von rechts unten durch eine Luftpumpe zugeführt und von einem Gebläse links oben in einen Luftkanal gespeist, der die Luft durch einen Wandabschnitt in dem Deckenbereich des in der Fig. 5 dieser Druckschrift gezeigten Raums führt, von wo aus die gereinigte Luft von oben in den Fertigungsraum eingespeist wird.

Der Erfindung liegt die Aufgabe zugrunde, ein Luftversorgungssystem für eine Anlage der eingangs genannten Art zu schaffen, welches eine möglichst effiziente und kostengünstige Versorgung von Zuluft mit der geforderten Reinheit gewährleistet.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Bei dem erfindungsgemäßen Luftversorgungssystem erfolgt die Luftzufuhr über den Boden des Reinraums. Ein wesentlicher Vorteil dieses Luftversorgungssystems besteht darin, daß dadurch die durch die Schwerkraft bedingte Zirkulation von Zuluft und Abluft ausgenutzt wird, so daß die Zuluft mit einem geringen Energieaufwand an den Orten für die Bearbeitung der Halbleiterprodukte zur Verfügung gestellt wird.

Diese Orte für die Bearbeitung der Halbleiterprodukte, insbesondere die unterschiedlichen Fertigungseinheiten sowie Transporteinrichtungen und Übergabestationen eines Transportsystems zum Transport der Halbleiterprodukte, befinden sich in Nähe des Bodens des Reinraums. Die Zuluft muß daher vom Boden des Reinraums bis zu den Orten für die Bearbeitung der Halbleiterprodukte nur eine kurze Wegstrecke zurücklegen, so daß hierfür nur ein geringer Energieaufwand notwendig ist. Dieser Effekt wird noch dadurch verstärkt, daß die erwärmte Abluft im Reinraum nach oben steigt und daher von der vom Boden des Reinraums zugeführten Zuluft nicht verdrängt werden muß.

In einer vorteilhaften Ausführungsform kann dabei die nach oben strömende Abluft über die Decke des Reinraums entsorgt werden. Auch dies ist mit geringem Energieaufwand möglich, da die Absaugung von Abluft durch die Konvektion der Abluft innerhalb des Reinraums unterstützt wird.

Bel dem erfindungsgemäßen Luftversorungssystem wird die Zuluft unmittelbar an den Bearbeitungsorten der Halbleiterprodukte im Bereich des Bodens eingespeist. Diese Zuluft ist kühler als die umgebende Abluft, welche infolge von Konvektion an die Decke des Reinraum hochsteigt. Somit ist gewährleistet, das sich im Bereich der Bearbeitungsorte der Halbleiterprodukte nahezu nur gereinigte Zuluft befindet und sich die Zuluft mit der Abluft in diesem Bereich nicht durchmischt. Dadurch wird erreicht, daß im Bereich der Bearbeitungsorte der Halbleiterprodukte Luft mit vorgeschriebenem Reinheitsgrad sowie gegebenenfalls mit der geforderten Temperatur und Feuchte zur Verfügung steht.

In einer vorteilhaften Ausführungsform der Erfindung wird die Zuluft über Gebläsevorrichtungen in vollständig oder teilweise abgeschlossene Fertigungseinrichtungen eingespeist. Dabei ist vom Boden des Reinraums über ein Kanalsystem die Zuluft zu der jeweiligen Gebläsevorrichtung geführt. Die Gebläsevorrichtungen sind dabei in unmittelbarer Nähe der Produktionseinrichtungen innerhalb der Fertigungseinheit angebracht. Dies ist deshalb vorteilhaft, da die Zuluft unmittelbar dort bereitgestellt wird, wo diese mit einem vorgegebenen Reinheitsgrad benötigt wird. Eine Beeinträchtigung durch verunreinigte Abluft kann bei dieser Anordnung nahezu vollständig ausgeschlossen werden. Schließlich ist vorteilhaft, daß sich die Anbringungsorte der Gebläsevorrichtungen üblicherweise in Bodennähe des Reinraums befinden, so daß für das Kanalsystem vom Boden des Reinraums bis zu den Gebläsevorrichtungen nur kurze Wegstrecken genötigt werden, was zu einem geringen Energie- und Kostenaufwand bei der Luftzufuhr führt. Die in der Fertigungseinheit befindliche kontaminierte und erwärmte Abluft steigt infolge von Konvektion nach oben. Diese Wärmebewegung der Abluft wird ausgenutzt, um sie mit geringem Energieaufwand über die Decke oder offene Oberseite der Fertigungseinheit abzusaugen und durch die Decke des Reinraums zu führen.

Die Erfindung wird im nachstehenden anhand der Zeichnungen erläutert. Es zeigen:
- Figur 1:: Schematische Darstellung einer Anlage zur Bearbeitung von Wafern mit mehreren Fertigungseinheiten in einem Reinraum.
- Figur 2:: Querschnitt durch ein Gebäude mit einem auf einer Etage angeordneten Reinraum gemäß Figur 1 sowie einem Luftversorgungssystem für den Reinraum.

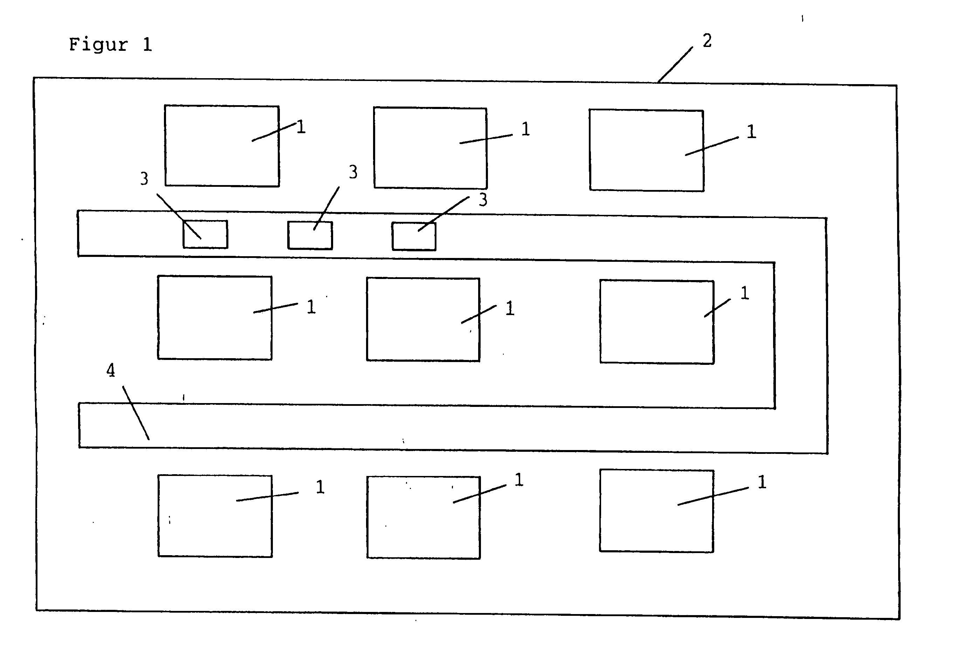

In Figur 1 ist eine Anordnung von Fertigungseinheiten 1 einer Anlage zur Bearbeitung von Wafern dargestellt. Die Fertigungseinheiten 1 sind in einem Reinraum 2 angeordnet und dienen zur Durchführung der bei der Bearbeitung der Wafer anfallenden Fertigungsprozesse. Diese Fertigungsprozesse umfassen insbesondere Ätzprozesse, Naßchemieverfahren, Diffussionsprozesse sowie Reinigungsverfahren. Zudem werden in den Fertigungseinheiten 1 die zur Kontrolle der Bearbeitungsqualität der einzelnen Fertigungsprozesse notwendigen Meßprozesse durchgeführt. Für sämtliche Fertigungsprozesse sind eine oder mehrere Fertigungseinheiten 1 vorgesehen.

Die Fertigungseinheiten 1 sind über ein Transportsystem verbunden, wobei den Fertigungseinheiten 1 über das Transportsystem mit Wafern befüllte Kassetten 3 zugeführt werden. Das Transportsystem weist ein Fördersystem auf, auf welchem die Kassetten 3 transportiert werden. Im vorliegenden Ausführungsbeispiel besteht das Fördersystem aus mehreren miteinander vernetzten Rollenförderern 4. Zudem kann das Transportsystem eine vorgegebene Anzahl von nicht dargestellten Speichern zur Zwischenlagerung der Wafer aufweisen.

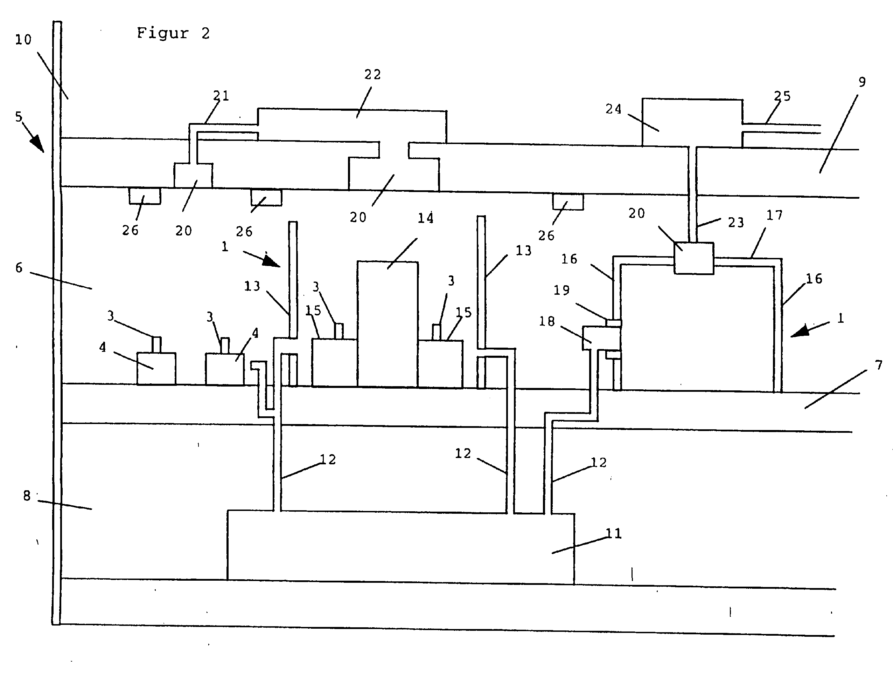

Wie aus Figur 2 ersichtlich ist, befindet sich die Fertigungseinheit 1 in einem Gebäude 5, wobei sich der Reinraum 2 mit den Fertigungseinheiten 1 auf einer Etage 6 des Gebäudes 5 befindet. Dabei ist in Figur 2 schematisch ein Ausschnitt dieses Gebäudes 5 dargestellt.

Für den Reinraum 2 ist ein Luftversorgungssystem vorgesehen, mittels dessen Zuluft über den Boden 7 des Reinraums 2 eingespeist wird. Die für das Luftversorgungssystem notwendigen Einrichtungen befinden sich daher im wesentlichen in der Etage 8 unterhalb des Reinraums 2. Dagegen wird Abluft über die Decke 9 des Reinraums 2 abgeleitet, so daß Einrichtungen hierfür in der Etage 10 oberhalb des Reinraums 2 angeordnet sind.

Die aus dem Reinraum 2 abgeführte Abluft sowie die dem Reinraum 2 zuzuführende Zuluft zirkulieren in einem nicht dargestellten Umluftsystem, wobei diesem je nach Bedarf Frischluft von außerhalb des Gebäudes 5 zugeführt wird. Die aus dem Reinraum 2 abgeführte verunreinigte Abluft wird dabei gereinigt um dann wieder als Zuluft dem Reinraum 2, gegebenenfalls mit Frischluft gemischt, zugeführt zu werden.

Bei dem in Figur 2 dargestellten Ausführungsbeispiel ist ein Vorratsbehälter 11 mit gereinigter Zuluft in der Etage 8 unterhalb des Reinraums 2 vorgesehen. Von diesem Vorratsbehälter 11 führt ein Kanalsystem mit mehreren Leitungen 12 durch den Boden 7 des Reinraums 2.

Erfindungsgemäß wird die Zuluft über die Leitungen 12 direkt zu den Orten im Reinraum 2 geführt, in welchem die Wafer bearbeitet werden. Dadurch wird erreicht, daß die Zuluft unmittelbar dort eingespeist wird, wo ein vorgegebener Reinheitsgrad der Zuluft benötigt wird.

Ein Beispiel hierfür ist ein Übergabestation für Wafer am Fördersystem des Transportsystems. Wie in Figur 2 dargestellt, verlaufen zwei Rollenförderer 4 abschnittsweise im Bereich des Bodens 7 des Reinraums 2 in geringem Abstand zueinander. Dieser Bereich bildet die Übergabestation. Dort können mittels nicht dargestellter Greifer oder durch das Bedienpersonal Kassetten 3 mit Wafern von einem Rollenförderer 4 auf den anderen verlegt werden. Bei derartig ausgebildeten übergabestationen ist die Anforderung an die Reinheit der Zuluft nicht besonders groß. Demzufolge ist es ausreichend, daß die Zuluft über die Leitungen 12 im Boden 7 des Reinraums 2 ohne weitere Reinigungsmaßnahmen direkt an der Übergabestation ausgeleitet wird. Da die Übergabestation in geringer Höhe oberhalb des Bodens 7 des Reinraums 2 liegt, ist der Energieaufwand für die Zuführung der Zuluft aus dem Boden 7 des Reinraums 2 entsprechend gering.

Weiterhin ist in Figur 2 eine Fertigungseinheit 1 dargestellt, welche über Wandelemente 13 vom übrigen Reinraum 2 abgetrennt ist. Die Wandelemente 13 umschließen einen personellen Arbeitsplatz 14, der beispielsweise als optische Inspektionseinrichtung ausgebildet ist. Dabei erstrecken sich die Wandelemente 13 nicht bis zur Decke 9 des Reinraums 2, so daß ein Zwischenraum zwischen der Decke 9 und der Fertigungseinheit 1 verbleibt, durch welchen ein Luftaustausch mit dem Rest des Reinraums 2 erfolgt. Die Kassetten 3 mit Wafern werden auf Ablageflächen 15 abgestellt. Danach entnimmt das Bedienpersonal einzelne Wafer, um sie mit optischen Geräten, beispielsweise mit Mikroskopen oder dergleichen auf ihre Bearbeitungsqualität zu prüfen. In diesem Fall wird die Zuluft über die Leitungen 12 des Kanalsystems zugeführt, welche die Wandelemente 13 der Fertigungseinheit 1 etwa in der Höhe der Ablageflächen 15 durchsetzen. Somit wird die gereinigte Zuluft direkt den Wafern auf den Ablageflächen 15 zugeführt. Dadurch wird erreicht, daß sich im Bereich der Wafer die Zuluft nicht mit der verbrauchten Abluft durchmischt, so daß am Bearbeitungsort der Wafer die notwendigen Reinheitsanforderungen an die Luftumgebung eingehalten werden. Weiterhin ist vorteilhaft, daß die Zuführung direkt oberhalb des Bodens 7 des Reinraums 2 erfolgt, so daß die Zuluft ohne großen Energieaufwand der Fertigungseinheit 1 zuführbar ist.

Schließlich ist in Figur 2 eine weitere Fertigungseinheit 1 dargestellt, welche von einer Maschine oder Anlage gebildet ist. Die Fertigungseinheit 1 ist nach allen Seiten durch Wandelemente 16 und eine Decke 17 vom Rest des Reinraums 2 abgetrennt, so daß kein Luftaustausch zwischen dem Inneren der Fertigungseinheit 1 und dem Reinraum 2 erfolgt.

Bei dieser Fertigungseinheit 1 handelt es sich beispielsweise um eine Anlage zur Reinigung von Wafern, bei welcher sehr hohe Reinheitsanforderungen an die Luft im Innern der Fertigungseinheit 1 bestehen.

In diesem Fall wird die Zuluft über eine an Leitungen 12 des Kanalsystems angeschlossene Gebläsevorrichtung 18 in das Innere der Fertigungseinheit 1 eingeblasen. Die Gebläsevorrichtung 18 weist einen schallgedämpften Antrieb sowie Filter zur Reinigung der Zuluft auf. Die Gebläsevorrichtung 18 befindet sich dabei in einer Andockstation 19 in einem Wandelement 16 der Fertigungseinheit 1. Dabei ist die Anbringhöhe der Andockstation 19 so gewählt, daß die Zuluft in derselben Höhe eingeblasen wird, in welcher die Wafer in nicht dargestellten Produktionseinheiten der Fertigungseinheit 1 bearbeitet werden. Die Zuluft wird somit wieder unmittelbar an den Bearbeitungsorten für die Wafer in die Fertigungseinheit 1 eingeführt. Dadurch wird verhindert, daß dort keine Durchmischung der gereinigten Zuluft mit verunreinigter Abluft erfolgt. Typischerweise liegen die Einbauhöhen derartiger Gebläsevorrichtungen 18 im Bereich zwischen 0,5m und 1,5m. Dies bedeutet, daß die Wegstrecken der Leitungen 12 vom Boden 7 des Reinraums 2 bis zu den Gebläsevorrichtungen 18 sehr kurz sind, so daß für die Zuleitung der Zuluft nur ein geringer Energiebedarf notwendig ist.

Üblicherweise wird in der Fertigungseinheit 1 Zuluft bei vorgegebenen Temperaturen benötigt, welche unterhalb der Temperatur im Reinraum 2 liegen. Daher ist an der Gebläsevorrichtung 18 zusätzlich eine nicht dargestellte Kühlvorrichtung vorgesehen.

Desweiteren werden an die Zuluft in derartigen Fertigungseinheiten 1 auch definierte Anforderungen an den Feuchtigkeitsgehalt der Zuluft gestellt. Zu diesem Zweck weisen dazu die entsprechenden Gebläsevorrichtungen 18 zusätzlich ebenfalls nicht dargestellte Vorrichtungen zur Trocknung oder Befeuchtung der Zuluft auf.

Zur Erfüllung der Anforderungen an die Temperatur und den Feuchtigkeitsgehalt der Zuluft ist es wiederum notwendig, daß die Gebläsevorrichtungen 18 in unmittelbarer Nähe der Bearbeitungsorte der Wafer angebracht sind. Nur dann ist gewährleistet, daß die Wafer unmittelbar mit der Zuluft beaufschlagt werden, und daß keine Durchmischung mit der Abluft im Reinraum 2 erfolgt.

Bei dem erfindungsgemäßen Luftversorgungssystem wird der Umstand ausgenutzt, daß die verbrauchte Abluft im Reinraum 2 oder in den Fertigungseinheiten 1 wärmer ist als die Zuluft und daher infolge von Konvektion nach oben aufsteigt.

Dementsprechend wird die Abluft über die Decken 17 der Fertigungseinheiten 1 und über die Decke 9 des Reinraums 2 ausgeleitet.

Bei dem in Figur 2 dargestellten Ausführungsbeispiel des Reinraums 2 sind hierzu in der Decke 9 zwei Absaugvorrichtungen 20 vorgesehen. Entsprechend der Menge der abzugsaugenden Abluft im Reinraum 2 sind an der Decke 9 weitere, nicht dargestellte Absaugvorrichtungen 20 vorgesehen. Da sich die erwärmte Abluft infolge von Konvektion nach oben bewegt, ist der Energiebedarf für diese Absaugvorrichtungen 20 relativ gering.

Die in Figur 2 dargestellten Absaugvorrichtungen 20 sind oberhalb der Übergabestation am Transportsystem und oberhalb der als personeller Arbeitsplatz 14 ausgebildeten Fertigungseinrichtung 1 angeordnet. Somit wird mit diesen Absaugvorrichtungen 20 Abluft aus diesen Bereichen abgesaugt.

Von den Absaugvorrichtungen 20 wird die Abluft direkt oder über Leitungen 21 eines Kanalsystems in eine Auffangeinrichtung 22 geführt und dort gesammelt. Von dort wird die Abluft dem nicht dargestellten Umluftsystem zugeführt. Hierzu können nicht dargestellte Gebläse, Leitungssysteme und dergleichen vorgesehen sein.

Die als Maschine oder Anlage ausgebildete und vom Rest des Reinraums 2 luftdicht getrennte Fertigungseinheit 1 weist an ihrer Decke 17 ebenfalls eine Absaugvorrichtung 20 auf. Über diese Absaugvorrichtung 20 wird kontaminierte Abluft in der Fertigungseinheit 1 abgesaugt. Durch die Bearbeitungsvorgänge innerhalb der Fertigungseinheit 1 wird die Abluft erhitzt und steigt infolge Konvektion nach oben, wodurch die Absaugung durch die Absaugvorrichtung 20 unterstützt wird. Der Energiebedarf für die Absaugvorrichtung 20 ist entsprechend gering. Von der Absaugvorrichtung 20 wird die Abluft über Leitungen 23 des Kanalsystems durch die Decke 9 des Reinraums 2 geführt und einer weiteren Auffangeinrichtung 24 zugeführt. Von dort wird die Abluft über eine weitere Leitung 25 dem Umluftsystem zugeführt.

Da die Abluft im Reinraum 2 nach oben abgesaugt wird, wird diese unmittelbar von den Bearbeitungsorten der Wafer, welche sich typischerweise im Bodenbereich des Reinraums 2 befinden entfernt. Diese Aufwärtsbewegung wird durch die Konvektion der Abluft unterstützt, da die zugeführte Zuluft kälter als die Abluft ist. Die Zuluft, die vom Boden 7 des Reinraums 2 direkt an die Bearbeitungsorte der Wafer in den Fertigungseinheiten 1 oder am Transportsystem eingespeist wird, verdrängt somit in diesen Bereichen die Abluft.

Damit wird in diesen Bereichen eine Durchmischung der Zuluft und Abluft weitgehend vermieden. Dadurch wird erreicht, daß an den bearbeitungsorten für die Wafer Zuluft mit dem geforderten Reinheitsgrad sowie mit der benötigten Temperatur und Feuchte zur Verfugung steht, was zu einer entsprechend hohen Bearbeitungsqualitat der Wafer führt.

Weiter ist vorteilhaft, daß nicht nur die erwärmte Abluft sondern im brandfall auch Rauch durch die Absaugvorrichtungen 20 zur Decke 9 des Reinraums 2 hin abgesaugt wird. Damit wird auch der Wirkungsgrand von an der Decke 9 des Reinraums 2 angebrachten kauchmeldern 26 beträchtlich erhöht.

## Patentansprüche

1. Anlage zur Fertigung von Halbleiterprodukten, insbesondere von Wafern, mit einer Anordnung von Fertigungseinheiten (1) in wenigstens einem Reinraum, der ein Luftversorgungssystem aufweist
**dadurch gekennzeichnet, dass**
das Luftversorgungssystem die Zuluft unmittelbar an den Bearbeitungsorten der Halbleiterprodukte durch den Boden des wenigstens einen Reinraums (2) einspeist.

2. Anlage nach Anspruch 1,
**dadurch gekennzeichnet, daß**
die Zuluft an einem Transportsystem zum Transport der Halbleiterprodukte eingespeist wird.

3. Anlage nach einem der Ansprüche 1 oder 2,
**dadurch gekennzeichnet, daß**
die Zuluft in die Fertigungseinheiten (1) eingespeist wird.

4. Anlage nach einem der Ansprüche 1 - 3, -
**dadurch gekennzeichnet, daß**
die Zuluft über ein im Boden (7) des Reinraums (2) verlaufendes Kanalsystem zugeführt wird.

5. Anlage nach einem der Ansprüche 1 - 4,
**dadurch gekennzeichnet, daß**
die Zuluft über Gebläsevorrichtungen (18) in den Reinraum (2) eingespeist wird.

6. Anlage nach Anspruch 5,
**dadurch gekennzeichnet, daß**
die Gebläsevorrichtungen (18) jeweils Filter zur Reinigung der Zuluft und schallgedämpfte Antriebe für das Gebläse aufweisen.

7. Anlage nach einem der Ansprüche 5 oder 6,
**dadurch gekennzeichnet, daß**
an den Gebläsevorrichtungen (18) Kühlvorrichtungen zur Kühlung der Zuluft vorgesehen sind.

8. Anlage nach einem der Ansprüche 5 - 7,
**dadurch gekennzeichnet, daß**
an den Gebläsevorrichtungen (18) Vorrichtungen zur Trocknung oder Befeuchtung der Zuluft vorgesehen sind.

9. Anlage nach einem der Ansprüche 3 - 8,
**dadurch gekennzeichnet, daß**
an den Fertigungseinheiten (1) Andockstationen (19) zur Einleitung der Zuluft vorgesehen sind, deren Anbringungsorte in unmittelbarer Nähe von Produktionseinrichtungen innerhalb der Fertigungseinheit (1) liegen.

10. Anlage nach Anspruch 9,
**dadurch gekennzeichnet, daß**
die Einbauhöhen der Andockstationen (19) im Bereich von 0,5m bis 1,5m liegen.

11. Anlage nach einem der Ansprüche 1 - 10,
**dadurch gekennzeichnet, daß**
im Reinraum (2) befindliche Abluft über die Decke (9) des Reinraums (2) ausgeleitet wird.

12. Anlage nach Anspruch 11,
**dadurch gekennzeichnet, daß**
die Abluft aus Fertigungseinheiten (1) über deren Decken (17) ausgeleitet wird.

13. Anlage nach Anspruch 12,
**dadurch gekennzeichnet, daß**
die über die Decke (17) einer Fertigungseinheit (1) ausgeleitete Abluft über ein Kanalsystem zur Decke (9) des Reinraums (2) geführt ist.

14. Anlage nach einem der Ansprüche 11- 13,
**dadurch gekennzeichnet, daß**
die Abluft mittels einer Absaugvorrichtung (20) über die Decke (9) des Reinraums (2) oder die Decke (17) einer Fertigungseinheit (1) absaugbar ist.

15. Anlage nach einem der Ansprüche 11 -16,
**dadurch gekennzeichnet, daß**
in der Decke (9, 17) oder oberhalb der Decke (9, 17) eines Reinraums (2) und / oder einer Fertigungseinheit (1) eine Auffangeinrichtung (22, 24) für die Abluft vorgesehen ist.

16. Anlage nach einem der Ansprüche 1 - 15,
**dadurch gekennzeichnet, daß**
an der Decke (9) des Reinraums (2) und / oder an den Decken (17) der Fertigungseinheiten (1) Rauchmelder (26) vorgesehen sind.

## Claims

1. Plant for producing semiconductor products, in particular wafers, having an arrangement of production units (1) in at least one clean room, which has an air supply system, **characterized in that** the air supply system feeds the feed air in immediately at the processing locations of the semiconductor products, through the floor of the at least one clean room (2).

2. Plant according to Claim 1, **characterized in that** the feed air is fed into a transport system for transporting the semiconductor products.

3. Plant according to either of Claims 1 and 2, **characterized in that** the feed air is fed into the production units (1).

4. Plant according to one of Claims 1 - 3, **characterized in that** the feed air is supplied via a duct system running in the floor (7) of the clean room (2) .

5. Plant according to one of Claims 1 - 4, **characterized in that** the feed air is fed into the clean room (2) via blowing devices (18).

6. Plant according to Claim 5, **characterized in that** the blowing devices (18) each have filters for cleaning the feed air and noise-reduced drives for the blower.

7. Plant according to either of Claims 5 and 6, **characterized in that** cooling devices for cooling the feed air are provided on the blowing devices (18).

8. Plant according to one of Claims 5 - 7, **characterized in that** devices for drying or humidifying the feed air are provided on the blowing devices (18).

9. Plant according to one of Claims 3 - 8, **characterized in that** docking stations (19) for the introduction of the feed air are provided on the production units (1), their fitting locations being located in the immediate vicinity of production devices within the production unit (1).

10. Plant according to Claim 9, **characterized in that** the installation heights of the docking stations (19) lie in the range from 0.5 m to 1.5 m.

11. Plant according to one of Claims 1 - 10, **characterized in that** waste air in the clean room (2) is led out via the ceiling (9) of the clean room (2).

12. Plant according to Claim 11, **characterized in that** the waste air is led out of production units (1) via their ceilings (17).

13. Plant according to Claim 12, **characterized in that** the waste air led out via the ceiling (17) of a production unit (1) is guided towards the ceiling (9) of the clean room (2) via a duct system.

14. Plant according to one of Claims 11 - 13, **characterized in that** the waste air can be extracted by means of an extraction device (20) above the ceiling (9) of the clean room (2) or the ceiling (17) of a production unit (1).

15. Plant according to one of Claims 11 - 16, **characterized in that** a collecting device (22, 24) for the waste air is provided in the ceiling (9, 17) or above the ceiling (9, 17) of a clean room (2) and/or a production unit (1).

16. Plant according to one of Claims 1 - 15, **characterized in that** smoke detectors (26) are provided on the ceiling (9) of the clean room (2) and/or on the ceilings (17) of the production units (1).

## Revendications

1. Installation de fabrication de produits semi-conducteurs, notamment de tranches, comprenant un agencement d'unités (1) de fabrication dans au moins une salle blanche, qui a un système d'alimentation en air,
**caractérisée en ce que**
le système d'alimentation en air injecte l'air affluent directement sur les emplacements de traitement des produits semi-conducteurs en passant à travers le plancher de la au moins une salle (2) blanche.

2. Installation suivant la revendication 1,
**caractérisée en ce que**
l'air affluent est injecté sur un système de transport des produits semi-conducteurs.

3. Installation suivant l'une des revendications 1 ou 2,
**caractérisée en ce que**
l'air affluent est injecté dans les unités (1) de fabrication.

4. Installation suivant l'une des revendications 1 à 3,
**caractérisée en ce que**
l'air affluent est apporté par un système de canalisation s'étendant dans le plancher (7) de la salle (2) blanche.

5. Installation suivant l'une des revendications 1 à 4,
**caractérisée en ce que**
l'air affluent est injecté par des dispositifs (18) d'insufflation dans la salle (2) blanche.

6. Installation suivant la revendication 5,
**caractérisée en ce que**
les dispositifs (18) d'insufflation ont respectivement un filtre d'épuration de l'air affluent et des dispositifs d'entraînement à atténuation du bruit des soufflantes.

7. Installation suivant l'une des revendications 5 ou 6,
**caractérisée en ce qu'**il
est prévu sur les dispositifs (18) d'insufflation des dispositifs de refroidissement de l'air affluent.

8. Installation suivant l'une des revendications 5 à 7,
**caractérisée en ce qu'**il
est prévu sur les dispositifs (18) d'insufflation des dispositifs de séchage ou d'humidification de l'air affluent.

9. Installation suivant l'une des revendications 3 à 8,
**caractérisée en ce qu'**il
est prévu sur les unités (1) de fabrication des postes (19) d'introduction de l'air affluent, dont l'emplacement se trouve à proximité immédiate de dispositifs de production au sein de l'unité (1) de fabrication.

10. Installation suivant la revendication 9,
**caractérisée en ce que**
la hauteur des postes (19) d'introduction est de l'ordre de 0,5 m à 1,5 m.

11. Installation suivant l'une des revendications 1 à 10,
**caractérisée en ce que**
de l'air vicié se trouvant dans la chambre (2) blanche est évacué par le plafond (9) de la salle (2) blanche.

12. Installation suivant la revendication 11,
**caractérisée en ce que**
l'air vicié provenant des unités (1) de fabrication est évacué par leur plafond (17).

13. Installation suivant la revendication 12,
**caractérisée en ce que**
de l'air vicié évacué par le plafond (17) d'une unité (1) de fabrication va par un système de canalisation au plafond (9) de la salle (2) blanche.

14. Installation suivant l'une des revendications 11 à 13,
**caractérisée en ce que**
l'air vicié peut être aspiré au moyen d'un dispositif (20) d'aspiration par le plafond (9) de la salle (2) blanche ou par le plafond (17) d'une unité (1) de fabrication.

15. Installation suivant l'une des revendications 11 à 16,
**caractérisée en ce qu'**il
est prévu dans le plafond (9, 17) d'une salle (2) blanche et/ou d'une unité (1) de fabrication un dispositif (22, 24) de capture de l'air vicié.

16. Installation suivant l'une des revendications 1 à 15,
**caractérisée en ce qu'**il
est prévu sur le plafond (19) de la salle (2) blanchet et/ou sur les plafonds (17) des unités (1) de fabrication des indicateurs (26) de fumée.
